# EUROPEAN PATENT APPLICATION

(11) **EP 1 780 782 A1**
(43) Date of publication of application: **02.05.2007**
(21) Application number: 05753357.2
(22) Date of filing: 21.06.2005
(51) Int. Cl.: H01L 21/60, H01L 21/52, B42D 15/10, G06K 19/07, G06K 19/077

(54) **APPARATUS FOR PRODUCING IC CHIP PACKAGE**

(30) Priority: 25.06.2004 JP 2004188115; 07.12.2004 JP 2004354069; 10.03.2005 JP 2005067589
(71) Applicant: Shinko Electric Co., Ltd, Minato-ku Tokyo 1058564 (JP)
(72) Inventor: INOUE, Taichi, c/o SHINKO ELECTRIC CO., LTD., Ise-shi, Mie 5160005 (JP); MORITA, M., SHINKO ELECTRIC CO., LTD., Ise-shi, Mie 5160005 (JP)
(74) Representative: Khan, Mohammed Saiful Azam
(86) International application number: PCT/JP2005/011373
(87) International publication number: WO 2006/001279

(57) **Abstract**

An IC chip package production apparatus of this invention comprises a conveyance portion which conveys a film substrate, and an IC chip mounting portion which mounts IC chips on the film substrate. The IC chip mounting portion comprises a mounting roller, on the outer face of which are formed a chip holding groove and a suction-clamping hole, which mounts IC chips on the film substrate by holding IC chips and rotating; an IC chip supply portion, having a supply path which supplies a plurality of IC chips successively; and a linear feeder which, with one supply end of the supply path opposing the chip holding groove and suction-clamping hole, feeds IC chips from the supply end to the chip-holding groove. The production apparatus further comprises a thermal pressure-bonding portion which performs thermal pressure-bonding of IC chips and the film substrate; this thermal pressure-bonding portion has a tape with magnets and a magnetic tape on the conveyor path conveying the film substrate, which apply pressure to the film substrate on the conveyor path without stopping the motion, and a heat-application portion which applies heat to the film substrate on the conveyor path without stopping the motion.

## Description

### TECHNICAL FIELD

This invention relates to an apparatus for producing IC chip packages such as, for example, ID tags.

Priority is claimed on Japanese Patent Application No. 2004-188115, filed June 25, 2004; Japanese Patent Application No. 2004-354069, filed December 7, 2004; and Japanese Patent Application No. 2005-67589, filed March 10, 2005, the entire contents of which are incorporated herein by reference.

### BACKGROUND ART

Recently, IC chip packages called RFID (Radio Frequency Identification) cards have appeared. These cards have internal memory and a small antenna, and by exchanging information with a reader antenna in a contact-free manner, can record necessary information in memory, and are capable of rapid recording, overwriting, and reading of information with a reader/writer or other communication equipment as necessary.

As an apparatus for producing IC chip packages such as these RFID cards, an apparatus has been proposed which conveys by means of a conveyor a base sheet having adhesive properties on one face, affixes a circuit sheet, on which have been formed an antenna circuit and an IC chip, to the adhesive face, and further affixes a cover sheet having adhesive properties on one face, to produce an IC chip package (see for example Patent Document 1). Further, an apparatus has been proposed which conveys by means of a conveyor a base sheet onto one face of which has been applied an adhesive, affixes a circuit sheet, similar to that described above, onto this adhesive face, and further affixes a cover sheet via the adhesive, to produce an IC chip package, as well as an apparatus which conveys by means of a conveyor a film substrate on one face of which is formed an antenna circuit, and mounts an IC chip so as to be connected to this antenna circuit to produce an IC chip package, and similar have been proposed (see for example Patent Documents 2 and 3).
- Patent Document 1:: Japanese Unexamined Patent Application, First Publication, No. 2003-6596 (Fig. 1)
- Patent Document 2:: Japanese Unexamined Patent Application, First Publication, No. 2003-58848 (Fig. 1)
- Patent Document 3:: Japanese Unexamined Patent Application, First Publication, No. 2003-168099 (Fig. 1)

Further, in order that the IC chip is bonded to the film substrate on which the antenna circuit is formed, in general an anisotropic conductive adhesive, requiring application of heat and pressure, is used.

However, the above apparatuses for producing IC chip packages of the prior art have the following problems. That is, in an apparatus of the prior art for producing IC chip packages, when mounting the IC chip on the film substrate, the base sheet or film substrate must be temporarily stopped to affix the circuit sheet or IC chip. Hence it is difficult to increase the speed of production of IC chip packages.

Further, when the circuit sheets or IC chips are affixed while continuously conveying the base sheet or film substrate, because a substantial amount of time is necessary to perform thermal pressure bonding of the base sheet or film substrate and the circuit sheet or IC chip using the anisotropic conductive adhesive, the mechanism for application of pressure and heat must be very long, so that much space is required.

### DISCLOSURE OF INVENTION

In light of the above problems, a first object of this invention is to provide an IC chip package production apparatus which produces IC chip packages at high speed, and which can stabilize the IC chip mounting position.

A second object of this invention is to provide an IC chip package production apparatus which reduces the space dedicated to the mechanism for application of heat and pressure.

In order to resolve the above problems, in this invention the following configuration is adopted. An apparatus for producing IC chip packages of this invention comprises a conveyance portion, which conveys a film substrate, and an IC chip mounting portion, which mounts IC chips on the film substrate. The IC chip mounting portion comprises a roller, on the outer surface of which is formed an IC chip holding portion, and which by rotating and holding IC chips mounts the IC chips on the film substrate; an IC chip supply portion, having a supply path which supplies the IC chips successively; and a chip feeder portion, which, with a supply end of the supply path opposed to the chip holding portion, feeds the IC chips from the supply end to the chip holding portion.

By means of this configuration, when the IC chip mounting portion mounts an IC chip on the film substrate, the roller moves the IC chip according to the speed of conveyance of the film substrate while performing the mounting. As a result, the IC chip can be mounted without temporarily stopping the film substrate, so that the efficiency of production of IC chip packages is improved. IC chips on the supply path are fed from the supply end of the supply path to the IC chip holding portion of the roller by the chip feeder portion, so that there is no need to provide another mechanism to transfer IC chips between the IC chip supply portion and the roller. By this means, the construction of the IC chip mounting portion can be made simple, and the apparatus reliability is improved.

Moreover, the number of IC chip packages which can be produced per unit time is increased, and the cost of IC chip packages can be lowered.

Further, in an IC chip package production apparatus of this invention, it is preferable that the roller be configured to enable approach toward and retreat from the supply end, and that a driving mechanism be provided to drive the approach and retreat of the roller.

By means of this configuration, the roller can be caused to approach the supply end of the supply path by the driving mechanism, and IC chips from the supply path can be fed to the IC chip holding portion.

Further, in an IC chip package production apparatus of this invention, it is preferable that a chip holding portion be provided at the supply end of the supply path, to temporarily hold and to halt the motion of the IC chips.

By means of this configuration, feeding of IC chips from the supply path is adjusted, so that feeding of IC chips is stabilized.

Further, in an IC chip package production apparatus of this invention, it is preferable that the chip holding portion comprise a suction-clamping mechanism for suction-clamping of the IC chips.

By means of this configuration, the IC chip is clamped by suction clamping, and feeding of the IC chips to the roller is adjusted.

Further, in an IC chip package production apparatus of this invention, the IC chip holding portion formed in the roller may comprise a plurality of compartments provided within the roller and suction holes opening from the compartments onto the outer surface, so that by controlling the air pressure within the compartments the IC chips are held or released.

Further, in an IC chip package production apparatus of this invention, it is preferable that the compartments provided within the roller change between a negative-pressure state and a positive-pressure state accompanying rotation of the roller.

By means of this configuration, IC chips are held and conveyed automatically accompanying the rotation operation of the roller, and upon approaching the film substrate, the state can be changed to a positive-pressure state to feed the IC chips.

Further, in an IC chip package production apparatus of this invention, it is preferable that the compartments provided within the roller comprise a gap within the roller and an air path switching valve.

By means of this configuration, the compartments can be changed between a negative-pressure state and a positive-pressure state accompanying roller rotation.

Further, in an IC chip package production apparatus of this invention, it is preferable that the air path switching valve comprise a negative-pressure pipe and a positive-pressure pipe.

By means of this configuration, IC chips successively supplied from the linear feeder by negative-pressure suction can be suction-clamped and conveyed, and by changing to positive pressure at a position approaching the film substrate, the IC chips can be affixed onto the film substrate.

An apparatus for producing IC chip packages of this invention comprises a conveyance portion, which conveys a film substrate; an IC chip mounting portion, which mounts IC chips on the film substrate; and a thermal pressure-bonding portion, which performs thermal pressure bonding of the IC chips and the film substrate. The thermal pressure-bonding portion has a pressure-application portion, which, on the conveyor path which conveys the film substrate on which IC chips are mounted, applies pressure to the film substrate on which the IC chips are mounted on the conveyor path without stopping the motion, and a heat-application portion, which applies heat to the film substrate on which the IC chips are mounted on the conveyor path without stopping the motion.

In an apparatus for producing IC chip packages with this configuration, a conveyor path is formed on the outer surface of the thermal pressure-bonding portion, and pressure can be applied to the film substrate on which IC chips are mounted by the pressure-application portion along this conveyor path; in addition, by applying heat using the heat-application portion and performing thermal pressure bonding, the space required for thermal pressure bonding can be reduced.

Further, in an IC chip package production apparatus of this invention, it is preferable that the conveyor path be provided on the outer surface of the thermal pressure-bonding portion or in a helical shape.

By means of an IC chip package production apparatus with this configuration, by forming the conveyor path so as to be wound in a helical shape, through the outer surface of the thermal pressure-bonding portion a longer conveyor path can be provided. Hence the space required for thermal pressure bonding can be further reduced.

Further, in an IC chip package production apparatus of this invention, it is preferable that the pressure-application portion comprise a pair of pressure-application tapes, positioned at both the upper and lower surfaces of the film substrate on which the IC chips are mounted, and having a relative attractive force, and that, by enclosing the film substrate on which are mounted the IC chips, pressure be applied to the film substrate on which the IC chips are mounted.

By means of an IC chip package production apparatus with this configuration, the film substrate with IC chips mounted is enclosed by a pair of pressure-application tapes having a relative attractive force, and by conveying the film substrate on the conveyor path while applying pressure, the film substrate on which are mounted the IC chips is thermal pressure-bonded.

Further, in an IC chip package production apparatus of this invention, it is preferable that the pair of pressure-application tapes applies pressure to the film substrate on which are mounted the IC chips by means of a magnetic attractive force.

By means of an IC chip package production apparatus with this configuration, the pair of pressure-application tapes having a relative magnetic attractive force enclose and apply pressure to the film substrate on which are mounted the IC chips.

Further, in an IC chip package production apparatus of this invention, it is preferable that an electrically conducting portion, which conducts a DC current in a direction intersecting the conveyor path, be comprised, and that the film substrate on which are mounted the IC chips be conveyed along the conveyor path by means of the Lorentz force arising between the tape with magnets due to the passed current.

By means of an IC chip package production apparatus with this configuration, a Lorentz force is induced by the tape with magnets which encloses the film substrate on which the IC chips are mounted, a magnetic film, and the electrically conducting portion, and the film substrate with the IC chips mounted, the tape with magnets, and the magnetic film are conveyed along the conveyor path. Here, by controlling the magnitude of the DC current due to the electrically conducting portion, the speed of conveyance of the film substrate can be adjusted.

Further, in an IC chip package production apparatus of this invention, it is preferable that discharge holes which discharges high-pressure air be formed in the conveyor path, and that conveyance be performed while lifting the film substrate on which are mounted IC chips and the pair of pressure-application tapes by means of high-pressure air.

By means of an IC chip package production apparatus with this configuration, the film substrate and pair of pressure-application tapes are lifted by high-pressure air, so that the friction coefficient during conveyance is reduced.

Further, in an IC chip package production apparatus of this invention, it is preferable that the heat-application portion discharge high-temperature high-pressure air from the discharge holes, to heat the film substrate on which IC chips are mounted.

By means of an IC chip package production apparatus with this configuration, high-temperature, high-pressure air is discharged from discharge holes to heat the film substrate, and in addition pressure is applied by the enclosing action of the pair of pressure-application tapes.

By means of an IC chip package production apparatus of this invention, when IC chips are mounted on a film substrate, the IC chips are mounted without temporarily stopping the film substrate, so that the efficiency of production of IC chip packages is improved. Moreover, there is no need to provide another mechanism to transfer IC chips between the IC chip supply portion and the roller, so that the construction of the IC chip mounting portion can be made simple, and the apparatus reliability is improved.

Further, by means of an IC chip package production apparatus of this invention, IC chips are mounted on a film substrate on which antenna circuits are formed, and when performing thermal pressure bonding, IC chips can be mounted and thermal pressure-bonded without temporarily stopping the film substrate, so that the efficiency of production of IC chip packages is improved. Hence the cost of IC chip packages can be reduced. Further, a conveyor path is formed in the outer surface of a cylindrical thermal pressure-bonding portion main unit, and thermal pressure bonding is performed while conveying the film substrate, onto which IC chips are mounted, along this conveyor path, so that the space required for thermal pressure bonding can be reduced.

### BRIEF DESCRIPTION OF THE DRAWINGS

Fig. 1A is a plane view showing an example of an ID tag produced by means of this invention;
Fig. 1B is a cross-sectional view showing the ID tag of Fig. 1A;
Fig. 2 is a plane view showing an example of the film substrate shown in Fig. 1A and Fig. 1B;
Fig. 3 is a side view schematically showing an apparatus for production of IC chip packages in a first embodiment of the invention;
Fig. 4 is a perspective view showing an IC chip supply portion of the IC chip package production apparatus shown in Fig. 3;
Fig. 5 is a cross-sectional view schematically showing a tip portion of a linear feeder of the IC chip supply portion shown in Fig. 4;
Fig. 6 is a perspective view showing a synchronous roller portion of the IC chip package production apparatus shown in Fig. 3;
Fig. 7 is a cross-sectional view schematically showing stop positions of suction holes due to an indexing operation of the synchronous roller portion shown in Fig. 6;
Fig. 8 is a top view showing the operation of the synchronous roller portion shown in Fig. 6;
Fig. 9 is a block diagram showing a control portion of the IC chip package production apparatus shown in Fig. 3;
Fig. 10 is a flowchart showing a procedure for production of ID tags in the first embodiment of the invention;
Fig. 11 is a flowchart showing a procedure for mounting IC chips in the procedure for production of ID tags in Fig. 10;
Fig. 12 is a perspective view showing another example of the synchronous roller portion of the IC chip package production apparatus shown in Fig. 3;
Fig. 13A is a cross-sectional view schematically showing the synchronous roller portion shown in Fig. 12;
Fig. 13B is a cross-sectional view taken along line A-A in Fig. 13A;
Fig. 14 is a top view showing an operation of the synchronous roller portion shown in Fig. 12;
Fig. 15 is a side view schematically showing an IC chip package production apparatus of a second embodiment of the invention;
Fig. 16 is a front view showing a thermal pressure-bonding portion of the IC chip package production apparatus shown in Fig. 15;
Fig. 17 is a bottom view showing the thermal pressure-bonding portion of the IC chip package production apparatus shown in Fig. 15;
Fig. 18 is a partially enlarged cross-sectional view showing the thermal pressure-bonding portion main unit shown in Fig. 17;
Fig. 19 is a flowchart showing a procedure for ID tag production in the second embodiment of the invention; and,
Fig. 20 is a flowchart showing a thermal pressure-bonding procedure in the ID tag production procedure of Fig. 19.

### BEST MODE FOR CARRYING OUT THE INVENTION

### [First Embodiment]

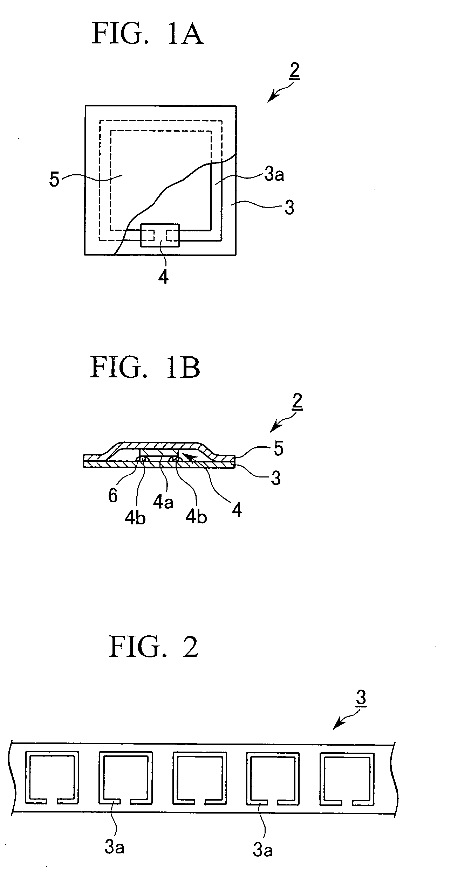

Below, a first embodiment of an IC chip package production apparatus of the invention is explained, referring to Fig. 1 through Fig. 9.

An IC chip package production apparatus 1 of this embodiment is a production apparatus which for example produces, as IC chip packages, ID tags 2.

As shown in Fig. 1, these ID tags 2 comprise a film substrate 3 on which is formed an antenna circuit 3a in a prescribed position, an IC chip 4 mounted in a prescribed position on the antenna circuit 3a, and a cover sheet 5.

The antenna circuit 3a is formed in advance on the film substrate 3 by a printing technique and etching, and as shown in Fig. 2, is formed continuously at equal intervals on the film substrate 3.

The IC chips 4 are provided on the bottom face 4a with bumps 4b, formed for example from silver or gold, to enable connection to the antenna circuits 3a, which are connected to the antenna circuits 4a via an adhesive 6 formed for example from an anisotropic conductive paste.

The cover sheet 5 has adhesive properties on one face, and covers the film substrate 3 and IC chips 4.

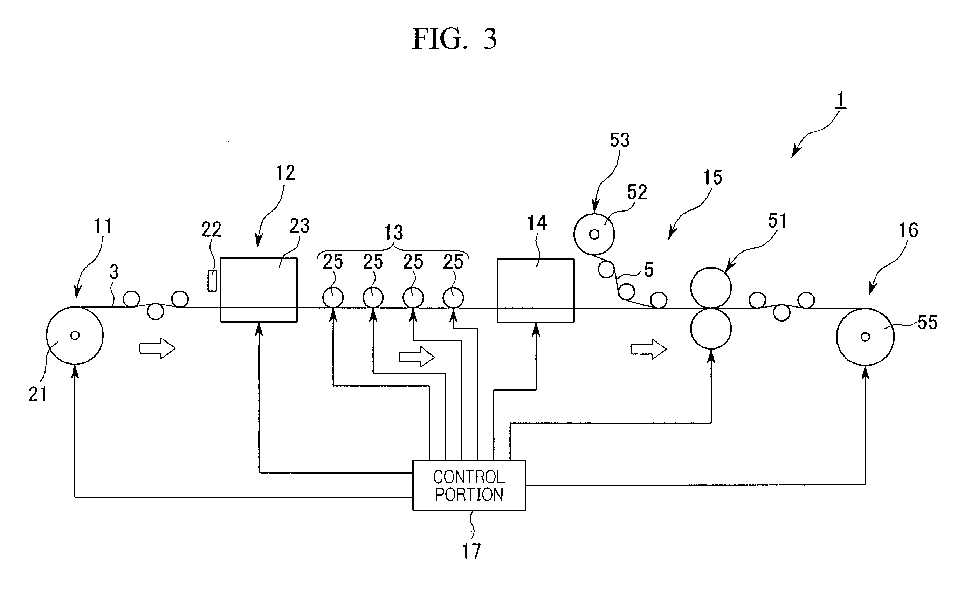

As shown in Fig. 3, this IC chip package production apparatus 1 comprises a film substrate accommodation portion (conveyor portion) 11, which accommodates the film substrate 3; an adhesive printing portion 12, which applies adhesive 6 to the positions of mounting of IC chips 4 on the film substrate 3; an IC chip mounting portion 13, which mounts the IC chips in prescribed positions of the film substrate 3; a heater 14, which dries the adhesive 6; a cover sheet affixing portion 15, which affixes a cover sheet onto the surface of the film substrate 3 on which IC chips 4 are mounted; a product take-up portion (conveyor portion) 16, which takes up the film substrate 3 to which the cover sheet 5 has been affixed; and a control portion 17, which controls these other constituent portions.

The film substrate accommodation portion 11 accommodates a roll 21 of the film substrate 3 shown in Fig. 2, and is controlled by the control portion 17 such that the film substrate 3 moves at a fixed velocity and is under a fixed tension.

Film substrate 3 fed from this film substrate accommodation portion 11 is continuously conveyed toward the adhesive printing portion 12.

The adhesive printing portion 12 comprises a CCD camera 22 and a printing portion 23 which applies adhesive 6 to prescribed positions of the film substrate 3. The position for application of the adhesive 6 is confirmed by means of the CCD camera 22, and is controlled by the control portion 17. The film substrate 3 fed from this adhesive printing portion 12 is continuously conveyed in the horizontal direction toward the IC chip mounting portion 13.

The IC chip mounting portion 13 comprises four mounting devices 25, which mount IC chips 4 onto the conveyed film substrate 3.

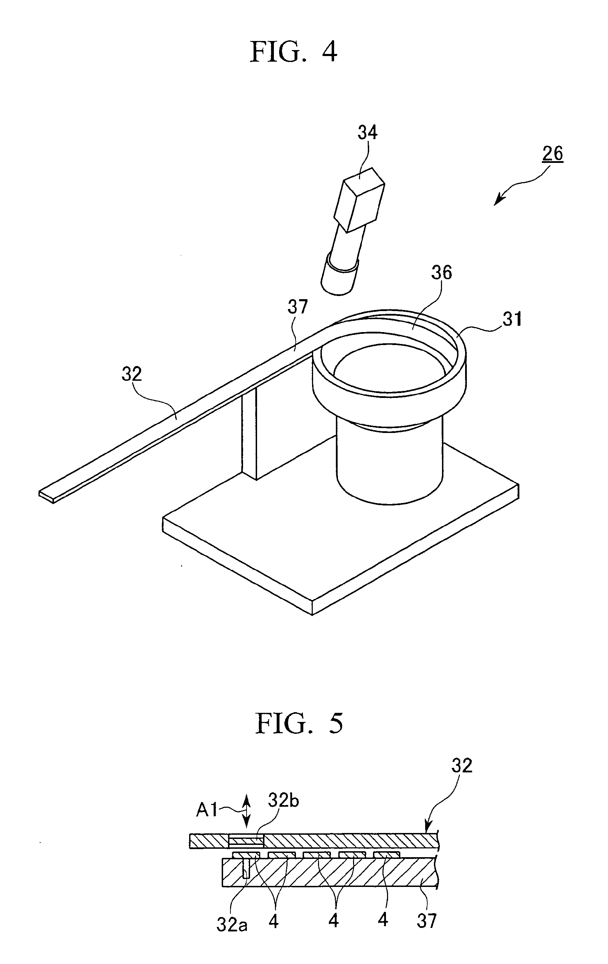

These mounting devices 25 each comprise an IC chip supply portion 26 and a synchronous roller portion 27, as shown in Fig. 4 through Fig. 8.

As shown in Fig. 4, an IC chip supply portion 26 comprises a bowl 31 which accommodates IC chips 4; a linear feeder (chip feeder portion) 32 which conveys IC chips 4 in a fixed direction at a fixed speed; a return feeder (not shown), which conveys IC chips 4 from the linear feeder 32 to the bowl 31; a vibration driver (not shown), which imparts vibrations to the linear feeder 32 and return feeder; and a CCD camera 34 which captures images of IC chips 4. As the method of imparting vibrations, for example, electromagnetic vibration may be used.

A helical-shaped conveyor path 36 is formed on the inner wall of the bowl 31, and accommodated IC chips 4 are conveyed on the conveyor path 36 at a fixed speed to the conveyor path 37 of the linear feeder 32 by means of vibrations.

The linear feeder 32 similarly conveys IC chips 4 which have been conveyed by the bowl 31 to the tip of the conveyor path (supply path) 36 by means of vibrations.

At the tip portion of the conveyor path 36, a suction-clamping hole (chip holding portion) 32a which suction-clamps IC chips 4 conveyed on the conveyor path 37, and a stopper (chip holding portion) 32b which encloses chips 4, are provided. The stopper 32b encloses IC chips 4 by rising and falling in the direction indicated by the arrow A1 in Fig. 5.

The suction clamping of IC chips 4 by the suction-clamping hole 32a, and enclosure of IC chips 4 by the stopper 32b, are controlled by the control portion 17. By intercepting IC chips conveyed on the conveyor path 37, the transfer of IC chips from the linear feeder 32 to the synchronous roller 41, described below, is adjusted.

CCD cameras 34 are positioned in substantially the center and at the tip of the conveyor path 37 of the linear feeder 32, and video signals captured by each are transmitted to the control portion 17.

An air blower is provided on the conveyor path 37, and when the control portion 17 judges that an IC chip an image of which has been captured by a CCD camera 34 is of the top (with the bump 4b facing downward), the IC chip 4 is ejected to the return feeder.

The return feeder ejects to the bowl 31 IC chips 4 which have been ejected by the air blower.

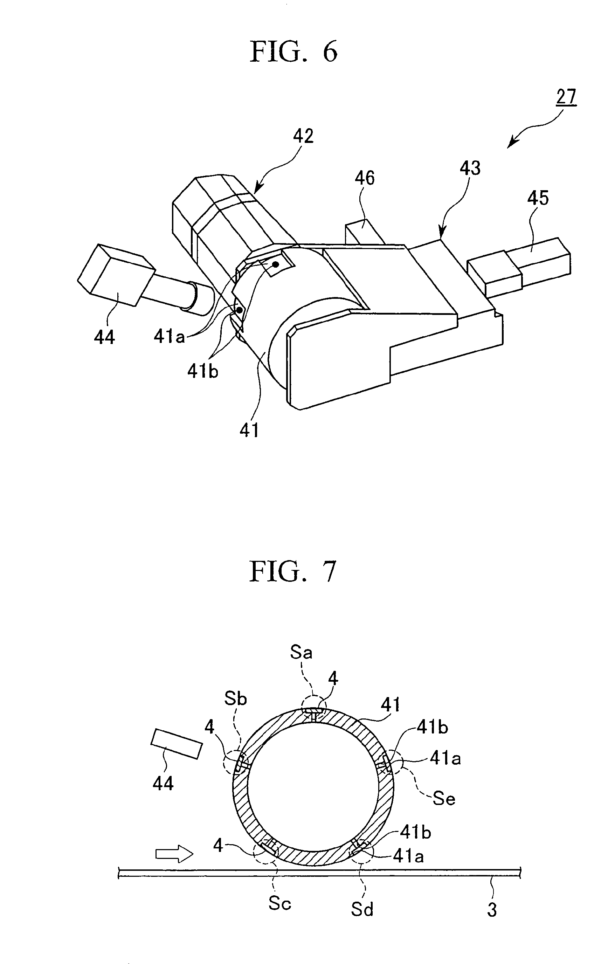

As shown in Fig. 6 through Fig. 8, the synchronous roller portion 27 comprises a synchronous roller 41; a driving motor 42, which operates the synchronous roller 41; a stage (driving mechanism) 43, which moves the synchronous roller 41 forward and backward, and right and left, relative to the film substrate 3; and a CCD camera 44 which captures images of IC chips 4 on the synchronous roller 41.

The synchronous roller 41 has a substantially columnar shape, and chip holding grooves (chip holding portions) 41 a are formed at equal intervals at five locations in the circumferential direction.

The chip holding grooves 41 a are formed on the side of the outer surface of the synchronous roller 41 opposing the linear feeder 32, such that the depth thereof is somewhat smaller than the thickness of the IC chips 4, and a suction-clamping hole (IC chip holding portion) 41 b is formed therewithin. IC chips conveyed from the linear feeder are placed in the chip holding grooves 41a, and by suction-clamping of the IC chips 4 by the suction-clamping holes 41 b, the IC chips 4 are positioned with stability.

The driving motor 42 is controlled by the control portion 17, and drives rotation such that the synchronous roller 41 stops at index positions set every 72° about the center axis of rotation. Through this indexing operation, the chip holding grooves 41a and suction-clamping holes 41b of the synchronous roller 41 temporarily stop at position Sa overlapping position Sc in the side view, as shown in Fig. 7, and at positions Sb through Se.

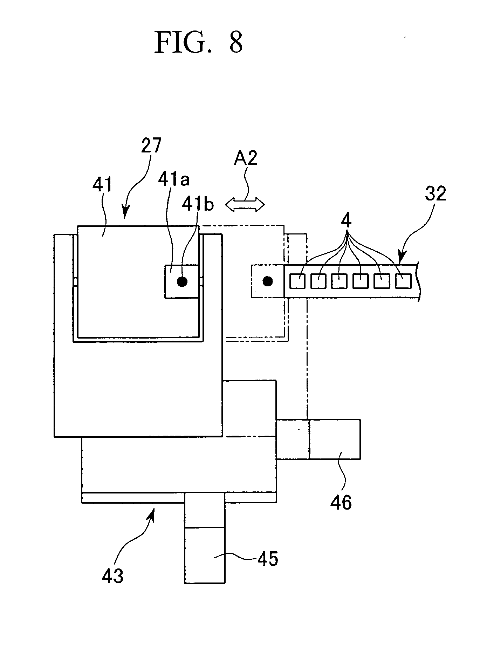

The stage 43 has an X-axis motor 45 and a Y-axis motor 46. By means of this stage 43, the synchronous roller 41 can approach toward and retreat from the linear feeder 32 in the direction indicated by the arrow A2 in Fig. 8. When the synchronous roller 41 is temporarily stopped by the indexing operation of the driving motor 42, the stage 43 causes the synchronous roller 41 to approach the linear feeder 32 and place an IC chip 4 in the chip holding groove 41a positioned at the position Sa. Thereafter, the synchronous roller 41 is made to retreat from the linear feeder 32. In Fig. 8, the driving motor 42 is omitted.

This stage 43 appropriately drives the X-axis motor 45 and Y-axis motor 46 to correct the position, using a correction amount calculated by the control portion 17 based on position information for the antenna circuit 3a on the film substrate 3 captured by the CCD camera 22 and position information for the IC chip 4 captured by the CCD camera 44.

Among the four mounting devices 25, one device placed in the position most removed from the film substrate accommodation portion 11 is a dedicated backup device for mounting IC chips on antenna circuits 3a on which an IC chip 4 has not been mounted by the other three IC chip mounting portions 13. That is, when an IC chip 4 has not been mounted on an antenna circuit 3 a because the bottom face was upward so that the chip was ejected to the return feeder, or was defective and so was not positioned at the suction-clamping hole 41b of the synchronous roller 41, an IC chip 4 is supplied from the backup device and is mounted on the antenna circuit 3a.

A heater 14 dries the adhesive 6 of the film substrate 3 on which IC chips 4 are mounted, and performs heating treatment.

An affixing portion 15 comprises a bonding roller 51, which affixes the film substrate 3 on which IC chips 4 are mounted to the cover film 5, and a cover film accommodation portion 53 which accommodates the roller 52 for the cover film 5.

The bonding roller 51 is a conveyor portion which together with the product take-up portion 16 conveys the film substrate 3 from the film substrate accommodation portion 11, draws cover film out from the cover film accommodation portion 53, and affixes the film substrate 3 and the cover film 5.

The product take-up portion 16 accommodates the ID tags 2 manufactured by affixing the cover film 5 as the take-up roll 55.

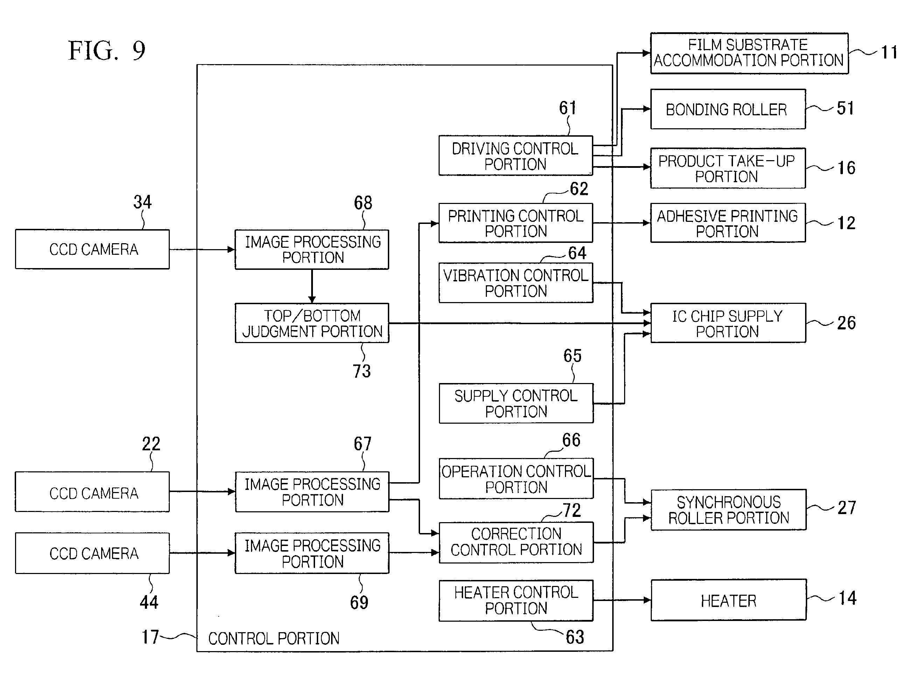

As shown in Fig. 9, the control portion 17 comprises a film substrate accommodation portion 11; driving control portion 61, which controls driving of the bonding roller 51 and product take-up portion 54; printing control portion 62, which controls driving of the adhesive printing portion 12; heater control portion 63, which controls driving of the heater 14; vibration control portion 64, which controls vibration of the IC chip supply portion 26; supply control portion 65, which controls suction-clamping of IC chips by the suction-clamping hole 32a and enclosure of IC chips 4 by the stopper 32b; and an operation control portion 66, which controls indexing operation of the synchronous roller portion 27 and the approach and retreat of the stage 43 toward and from the linear feeder 32. The control portion 17 further comprises image processing portions 67, 68, 69, which perform image processing of images captured by the CCD cameras 22, 36, 44 respectively; a correction control portion 72, which transmits correction amounts, obtained from images processed by the image processing portions 67, 69 to the stage 43 of the synchronous roller portion 27; and a top/bottom judgment portion 73, which judges whether the top or bottom of IC chips 4 is seen in images processed by the image processing portion 68 and controls the IC chip supply portion 26 accordingly.

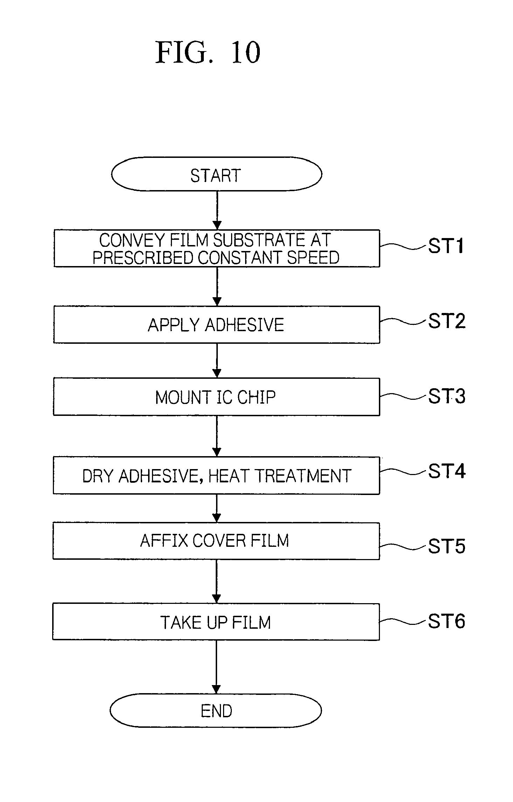

Next, an ID tag production method is explained using Fig. 10.

First, the bonding roller 51 and product take-up portion 16 convey film substrate 3 from the film substrate accommodation portion 11 at a fixed speed to the adhesive printing portion 12 (step ST1).

Next, the CCD camera 22 of the adhesive printing portion 12 captures an image of the antenna circuit 3a of the film substrate 3, and based on the captured image, the image processing portion 67 confirms the position of the antenna circuit 3a formed on the film substrate 3. Based on this position information, the printing portion 23 uses an application device, such as a rotary press, to apply adhesive 6 to the positions at which IC chips 4 are to be mounted on the film substrate 3, without stopping the film substrate 3 (step ST2).

Next, a chip mounting portion 13 mounts IC chips 4 at a prescribed position of the antenna circuits 3a (step ST3).

Next, the heater 14 heats the film substrate 3 on which are mounted the IC chips 4, and by hardening the adhesive 6, fixes the IC chips 4 to the film substrate 3 (step ST4).

Thereafter, the affixing portion 15 affixes the cover film so as to cover the antenna circuits 3a and IC chips 4 (step ST5).

Finally, the product take-up portion 16 takes up the film substrate 3 onto which the cover film 5 has been affixed (step ST6).

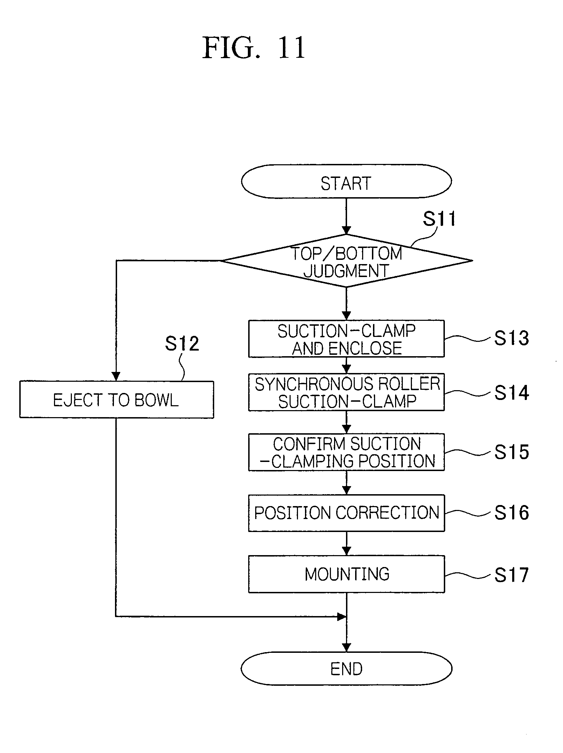

Next, the method of mounting IC chips 4 by a chip mounting portion 13 is explained in detail using Fig. 11.

First, the vibration control portion 64 drives the vibration driver, causing the IC chip supply portion 26 to convey IC chips 4 in the bowl 31 to be conveyed continuously, at constant speed and at equal intervals, on the conveyor path 37. At this time, the CCD camera 34 captures images from the top side of IC chips 4 being conveyed on the conveyor path 37 of the linear feeder 32, and the image processing portion 68 of the control portion 17 judges whether the top or the bottom of the IC chips 4, images of which have been captured by the CCD camera 34, is visible (step ST11). Here, the face on which a bump 4b is provided is the bottom face.

In step ST11, when the image processing portion 68 judges that the face of an IC chip 4 is the top face, the top/bottom judgment portion 73 ejects the IC chip 4 to the return feeder. The ejected IC chip 4 is conveyed by the return feeder to the bowl 31 (step ST12).

In step ST11, when the top/bottom judgment portion 73 judges that the face of the IC chip 4 is the bottom face, the linear feeder 32 conveys the IC chip 4 toward the tip of the conveyor path 37. The suction-clamping hole 32a and stopper 32b intercept the conveyed IC chip 4 by means of suction-clamping and enclosing (step ST13).

The synchronous roller 41 undergoes an indexing operation in which the driving motor 42 stops the roller at every 72° of rotation.

While the synchronous roller 41 is temporarily stopped in this indexing operation, the stage 43 causes the synchronous roller 41 to approach the linear feeder 32. The supply control portion 65 releases the suction-clamping and enclosure of the IC chip 4, and the linear feeder 32 transfers the IC chip 4 to the chip holding groove 41 a at the position Sa shown in Fig. 7. When the IC chip 4 has been transferred to the chip holding groove 41 a, the stage 43 causes the synchronous roller 41 to retreat from the linear feeder 32, as shown in Fig. 8 (step ST14).

Next, the synchronous roller 41 further performs indexing operation to move the IC chip 4 which has been transferred from the linear feeder 32 to the position Sb shown in Fig. 7. In this state, the CCD camera 44 captures an image of the IC chip 4 on the synchronous roller 41 (step ST15). The correction control portion 72 computes the amount of correction of the position of the synchronous roller 41 from position information for the antenna circuit 3a obtained by the image processing portion 67 and from position information for the IC chip 4 obtained by the image processing portion 69. While the synchronous roller 41 is temporarily stopped due to indexing operation, the stage 43 causes the synchronous roller 41 to approach the linear feeder 32, and the IC chip 4 is transferred.

The synchronous roller 41 performs an indexing operation, and moreover the stage 43 corrects the position of the synchronous roller 41 by means of the correction control portion 72 (step ST16).

Then, the synchronous roller 41 undergoes further indexing operation, and the synchronous roller 41 is moved downward, causing contact between the film substrate 3 and the IC chip 4 at the position Sc and position Sd shown in Fig. 7, the IC chip 4 is released from the suction-clamping hole 41b, and the IC chip 4 is mounted on the film substrate 3 (step ST17). The position of contact of the synchronous roller 41 and film substrate 3 is the position opposing the position at which the IC chip 4 is released from the rotary head 27 to the synchronous roller 41. Hence at the position of contact with the film substrate 3, the IC chip 4 does not stop due to the indexing operation, but is positioned on the film substrate 3.

There will be cases in which, because the bottom face of the IC chip 4 is on top and so the chip is ejected to the return feeder, or because the IC chip 4 is defective and so is ejected, no IC chips 4 have been suction-clamped by the suction-clamp holes 41b of any of the synchronous rollers 41 in the three mounting devices 25. When no IC chip 4 has been mounted on such an antenna circuit 3 a, an IC chip 4 is mounted by the dedicated backup mounting device 25.

By means of an IC chip package production apparatus configured in this way, IC chips 4 are mounted without temporarily halting the film substrate 3, so that the efficiency of production of ID tags 2 is improved.

Further, IC chips 4 are supplied by causing the synchronous roller 41 to approach the linear feeder 32, so that there is no need to provide another mechanism to transfer IC chips 4 between the IC chip supply portion 26 and the synchronous roller portion 27. By this means, the construction of the IC chip mounting portions 13 can be simplified, and device reliability is improved.

Further, by providing a suction-clamping hole 32a and stopper 32b, transfer of the IC chip 4 by the linear feeder 32 is adjusted, and transfer of the IC chip 4 is rendered stable.

Further, because IC chips 4 are mounted using three mounting devices 25, the number of IC chip packages which can be produced per unit time is increased.

In the above embodiment, an apparatus for production of ID tags has been explained; but application to an apparatus for production of cards on which are mounted IC chips is also possible.

Further, an example has been explained in which the IC chip mounting portion comprises four mounting devices; but the number of mounting devices may be one, or may be another number greater than one.

Further, an example has been explained in which one backup mounting device is provided; but a plurality of backup devices may be provided, or none may be provided.

Further, an example has been explained in which antenna circuits are formed on the film substrate; by positioning a device to fabricate antenna circuits before the adhesive printing device, an apparatus may be obtained in which film substrate without antenna circuits formed is supplied.

Further, a construction may be employed in which the cover film covers so as to enclose the antenna circuits and IC chips.

Further, the roller 21 of the film substrate may be freely rotatable.

Further, the driving motor 41 may be incorporated within a housing.

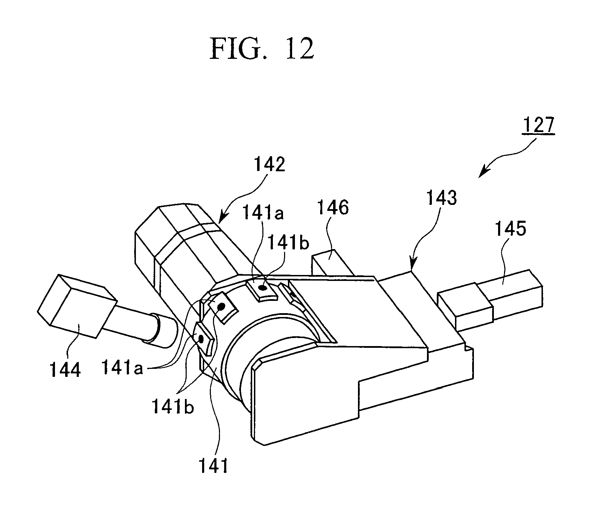

Next, an example of another configuration of the synchronous roller portions, which perform mounting of IC chips at prescribed positions on the film substrate 3 in an IC chip package production apparatus, is explained referring to Fig. 12 through Fig. 14.

Referring to Fig. 12, a synchronous roller portion 127 comprises a synchronous roller 141; a driving motor 142 which operates the synchronous roller 141; a stage (driving mechanism) 143 which moves the synchronous roller 141 forward and backward, and right and left, relative to the film substrate 3; and a CCD camera 144 which captures images of IC chips 4 on the synchronous roller 141.

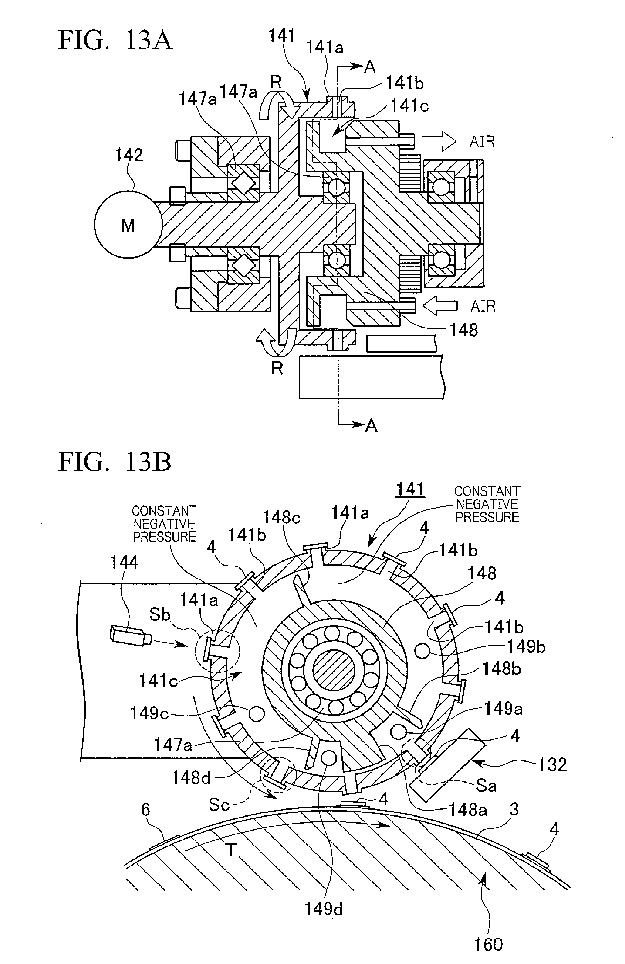

The synchronous roller 141 has substantially a cylindrical shape as shown in Fig. 13B, and protruding portions (IC chip holding portions) 141 a are formed at equal intervals at ten locations in the circumferential direction thereof. As shown in Fig. 13A, the protruding portions 141 a are formed on the outer surface of the synchronous roller 141 on the side opposing the conveyor path 132 on which IC chips, fed from the linear feeder in a state of straight-line arrangement, are conveyed, and have suction-clamping holes (IC chip holding portions) 141b. The synchronous roller 141 is rotatably supported by bearings 147a and 147b, and is driven in rotation in the direction of the arrow R by the driving motor 142. An air path switching valve 148 is positioned in the gap 141c of the synchronous roller 141. The air path switching valve 148 has a plurality of vanes 148a to 148d, which are in positions fixed with respect to the synchronous roller 141. The gap 141c of the synchronous roller 141 and the vanes 148a to 148d form a plurality of compartments. A pipe 149a is provided in the compartment formed between the vane 148a and the vane 148b, enabling switching between atmospheric pressure and negative pressure by an external electromagnetic valve or other air pressure control device. The compartment formed between the vane 148a and the vane 148b is positioned in opposition to the conveyor path 132 of the linear feeder. Hence when the suction-clamping hole 141b formed in the synchronous roller 141 is positioned in this compartment, an IC chip conveyed from the conveyor path 132 is suction-clamped in place. This suction-clamping may be used together with an ionizer for the purpose of removing static electricity.

A negative-pressure pipe 149b is provided in the compartment formed between the vane 148b and the vane 148c, and the compartment is maintained in a constant negative-pressure state. A negative-pressure pipe 149c is also provided in the compartment formed between the vane 148c and the vane 148d, and the compartment is maintained in a constant negative-pressure state. Hence suction-clamped IC chips 4 can be held and conveyed by the suction-clamping hole 141 b with rotation of the synchronous roller 141 and can be positioned with stability. Moreover, a positive-pressure pipe 149d is provided in the compartment formed between the vane 148d and the vane 148a, and the compartment is maintained in a constant positive-pressure or atmospheric-pressure state. This compartment is positioned in proximity to the film substrate 3.

The driving motor 142 causes indexing operation to be performed, in which the synchronous roller 141 is rotated at a pitch of 36° about the rotation axis and then stopped. By means of this indexing operation, the protruding portions 141a and suction-clamping holes 141b (IC chip holding portions) of the synchronous roller 141 are stopped temporarily at positions overlapping the positions Sa and Sc in a side view, as in Fig. 13B; and synchronous rotation, stoppage, IC chip suction clamping, and synchronous rotation are repeated in order.

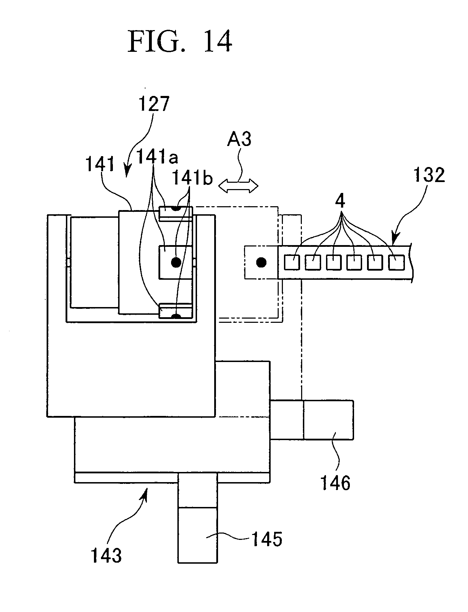

The stage 143 has an X-axis motor 145 and Y-axis motor 146. By means of this stage 143, the synchronous roller 141 can be made to approach toward and retreat from the conveyor path 132 of the linear feeder in the direction indicated by the arrow A3 in Fig. 14. As shown in Fig. 14, this stage 143 causes the synchronous roller 141 to approach the conveyor path 132 of the linear feeder when the synchronous roller 141 is temporarily stopped due to the indexing operation of the driving motor 142, and an external electromagnetic valve or other air pressure control device causes the compartment between the vane 148a and the vane 148b to go to negative pressure, via the pipe 149a. By this means, an IC chip 4 is suction-clamped by the protruding portion 141a positioned at the position Sa, and the synchronous roller 141 is caused to retreat from the conveyor path 132 of the linear feeder. In Fig. 14, the driving motor 142 is omitted. Also, the position of the conveyor path 132 is shown schematically.

This stage 143 can use a correction amount, computed by the control portion based on position information for the antenna circuit 3a on the film substrate 3 as captured by a CCD camera, not shown, and on position information for the IC chip according to the CCD camera 144, to perform position correction by appropriately driving the X-axis motor 145 and Y-axis motor 146. In place of the X-axis motor 145, position correction may be performed by means of the rotation amount of the synchronous roller and driving motor in Fig. 12.

Next, processes in the production of ID tags by the above-described apparatus are described in summary.

First, prior to suction-clamping of an IC chip 4, a judgment is made as to whether the IC chip is in a prescribed orientation (in general, with the top face upward), and with the chip judged to be in the prescribed orientation as a condition, the IC chip 4 is supplied to a suction-clamping position of the synchronous roller 141. An IC chip which is judged to have the bottom face upward is returned to the part feeder or other component supply portion via a return conveyor path, not shown.

The synchronous roller 141 performs an indexing operation, rotating by 36° each time, by means of the driving motor 142. While the synchronous roller 141 is temporarily stopped due to the indexing operation, the stage 143 causes the synchronous roller 141 to approach the conveyor path 132, as shown in Fig. 14. In this state, the conveyor path 132 transfers an IC chip 4 to the protruding portion 141a in the position Sa shown in Fig. 13B. When the IC chip 4 has been placed on the protruding portion 141 a, the stage 143 causes the synchronous roller 141 to retreat from the conveyor path 132, as shown in Fig. 14.

The synchronous roller 141 performs further indexing operation to move the IC chip 4 transferred from the conveyor path 132 to the position Sb shown in Fig. 13B. At this time, the CCD camera 144 captures an image of the IC chip 4 on the synchronous roller 141. Using the image thus captured, and based on position information for the IC chip 4 and position information for the antenna circuit 3a on the film substrate 3 according to another CCD camera, not shown, a position correction amount is computed by a control portion, not shown.

Thereafter, through rotation of the synchronous roller 141, the IC chip 4 is caused to make contact with the film substrate 3 between the position Sc and the position Sa shown in Fig. 13B, the IC chip is released from the suction-clamping hole 141b, and the IC chip 4 is mounted on a position on the film substrate 3 to which anisotropic conductive adhesive or similar has been applied. The IC chip 4 is positioned on the film substrate 3 at the position of contact with the film substrate 3, without stoppage of rotation by the synchronous roller 141.

By means of an IC chip package production apparatus configured in this way, IC chips 4 are mounted without temporarily stopping the film substrate 3, so that the efficiency of production of ID tags 2 is improved.

In this embodiment, as shown in Fig. 13B, the film substrate 3 is conveyed and supported nonstop in the direction of the arrow T by the surface-supporting roller (clock roller) 160, extending from in front of to behind the IC chip mounting positions. By causing the synchronous roller 141 to approach the conveyor path 132, an IC chip 4 is supplied, and so there is no need to provide another mechanism to transfer IC chips 4 between the IC chip supply portion 132 and the synchronous roller 141. By this means, the construction of the IC chip mounting portions can be simplified, and device reliability is improved.

Various modifications can be made to the above configuration.

For example, the synchronous roller 141 in the above explanation was provided with protruding portions (IC chip holding portions) 141 in ten locations; but the number may be greater or smaller than this.

Also, an ionizer may be used to eliminate static electricity where appropriate on the IC chip conveyor path.

Moreover, by providing a groove in the bottom face of the conveyor path with which IC chips make contact, to avoid phenomena in which IC chips are in close planar contact with the bottom face of the transport path, the occurrence of static electricity can be effectively prevented.

### [Second Embodiment]

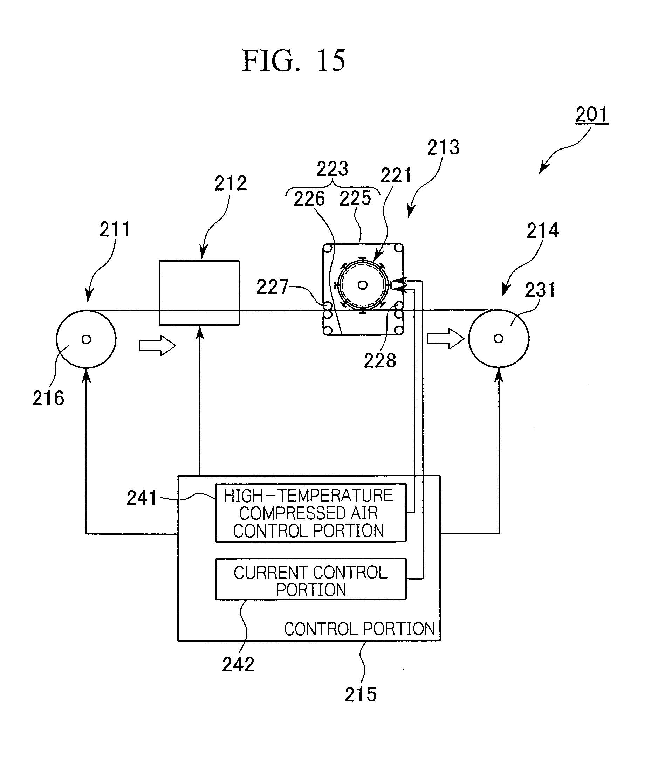

Next, the IC chip package production apparatus of a second embodiment of the invention is explained, referring to Fig. 15 through Fig. 20.

As shown in Fig. 15, the IC chip package production apparatus 201 of the second embodiment comprises a film substrate accommodation portion 211, which accommodates film substrate 3; an IC chip mounting portion 212, which mounts IC chips 4 at prescribed positions on the film substrate 3; a thermal pressure-bonding portion 213, which performs thermal pressure-bonding of IC chips 4 and the film substrate 3; a product take-up portion 214, which takes up the film substrate 3 on which are mounted the IC chips 4; and, a control portion 215 which controls these portions.

The film substrate accommodation portion 211 accommodates a roll 216 of the film substrate 3 shown in Fig. 2, and is controlled by the control portion 215 such that the film substrate 3 moves at a fixed velocity and is under a fixed tension. Film substrate 3 fed from this film substrate accommodation portion 211 is continuously conveyed toward the IC chip mounting portion 212.

The IC chip mounting portion 212 mounts IC chips 4 on the antenna circuits 3a of the conveyed film substrate 3, and conveys the film substrate 3 to the thermal pressure-bonding portion 213.

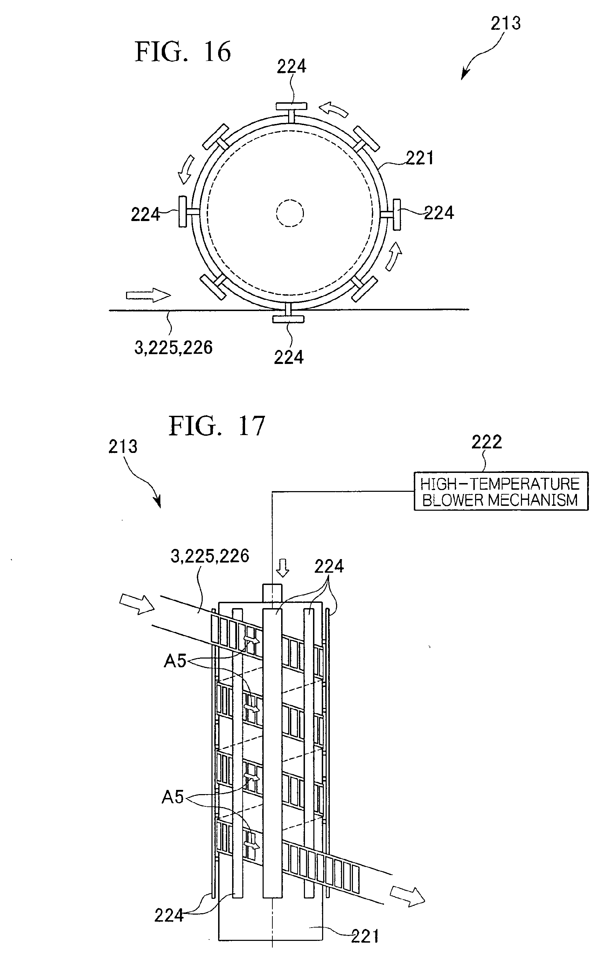

As shown in Fig. 16 through Fig. 18, the thermal pressure-bonding portion 213 comprises a thermal pressure-bonding main unit 221, on the outer surface of which is provided a conveyor path on which is conveyed the film substrate 3 on which are mounted IC chips 4; a high-temperature blower mechanism (heating portion) 222, which heats the film substrate 3 on which IC chips 4 are mounted on the conveyor path while being conveyed; and a pressure-application portion 223, which applies pressure to the film substrate 3 on which IC chips 4 are mounted on the conveyor path while being conveyed.

The thermal pressure-bonding main unit 221 has substantially a cylindrical shape, on the outer surface of which is provided a conveyor path which conveys the film substrate 3 on which IC chips 4 are mounted, wound into a helical shape. A spray hole (discharge hole) 221a, which sprays high-temperature compressed air from the high-temperature blower mechanism 222 along the conveyor path, is formed in this thermal pressure-bonding main unit 221, and the film substrate 3 conveyed on the conveyor path is lifted from the outer surface of the thermal pressure-bonding main unit 221 and heated. Further, sheet-shaped electrically conducting bars (conductive portions) 224, having conductivity at equal intervals in the circumferential direction of the thermal pressure-bonding main unit 221, are positioned across a gap from the outer surface of the thermal pressure-bonding main unit 221.

The pressure-application portion 223 comprises tape with magnets (pressure application tape) 225 and magnetic tape (pressure application tape) 226, positioned on either side of the film substrate 3 on which are mounted IC chips 4.

The tape with magnets 225 and the magnetic tape 226 are positioned at the upper and lower surfaces of the film substrate 3 by the placement roller 227 shown in Fig. 15 before the film substrate 3 with IC chips 4 mounted is conveyed to the thermal pressure-bonding main unit 221, and after the film substrate 3 is conveyed from the thermal pressure-bonding main unit 221, are separated from the film substrate 3 by the separating roller 228 shown in Fig. 15. The tape with magnets 225 and magnetic tape 226 are connected at the conveyance points of entry and exit to form endless loops.

The tape with magnets 225 has permanent magnets positioned on one face, and is configured such that a magnetic attractive force with the magnetic tape 226 occurs. The tape with magnets 225 and magnetic tape 226 positioned at the upper and lower faces of the film substrate 3 on which are mounted IC chips 4 enclose the film substrate 3 by means of this magnetic attractive force, and apply pressure to the IC chips 4 and film substrate 3.

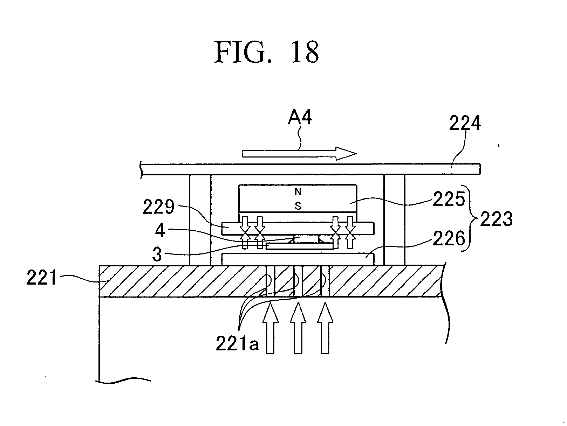

By passing a DC current through the conducting bars 224 in the direction of the arrow A4 in Fig. 18, a Lorentz force is made to act on the tape with magnets 225. Due to this Lorentz force, the film substrate 3, tape with magnets 225 and magnetic tape 226 are conveyed in the direction indicated by the arrow A5 in Fig. 17 along the outer surface of the thermal pressure-bonding portion main unit 221. High-temperature compressed air causes the film substrate 3, tape with magnets 225 and magnetic tape 226 to be lifted, so that conveyance is smooth.

The magnitude of the DC current passed through the conducting bars 224 is controlled such that the conveyance speed with which the film substrate 3, tape with magnets 225 and magnetic tape 226 are conveyed by the Lorentz force along the outer surface of the thermal pressure-bonding portion main unit 221 is a constant velocity synchronized with the speed of conveyance of the film substrate 3.

The gap between the above-described thermal pressure-bonding portion main unit 221 and the conducting bars 224 is greater than the thickness when the tape with magnets 225 and magnetic tape 226 are positioned on both faces of the film substrate 3 with IC chips 4 mounted. As shown in Fig. 18, spacers 229 may also be introduced between the tape with magnets 225 and film substrate 3 in order to adjust the pressure of the magnetic attractive force.

The product take-up portion 214 accommodates the ID tags 2 thus produced in the form of a take-up roll 231.

The control portion 215 comprises a high-temperature compressed-air control portion 241, which controls the air flow and temperature of the high-temperature blower mechanism 222, and a current control portion 242, which controls the current flowing in the conducting bar 224.

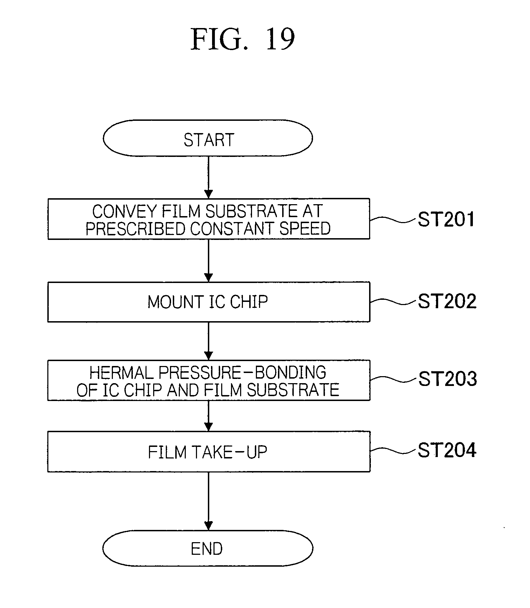

Next, the method of ID tag production in the second embodiment is explained using Fig. 19.

First, the product take-up portion 214 conveys the film substrate 3 from the film substrate accommodation portion 211 to the chip mounting portion 213 at a fixed speed (step ST201).

Next, the chip mounting portion 213 mounts IC chips 4 in prescribed positions of antenna circuits 3a (step ST202).

Thereafter, the thermal pressure-bonding portion 213 performs thermal pressure-bonding of the IC chips 4 and film substrate 3 (step ST203).

Finally, the product take-up portion 214 takes up the film substrate 3 with IC chips 4 mounted (step ST204).

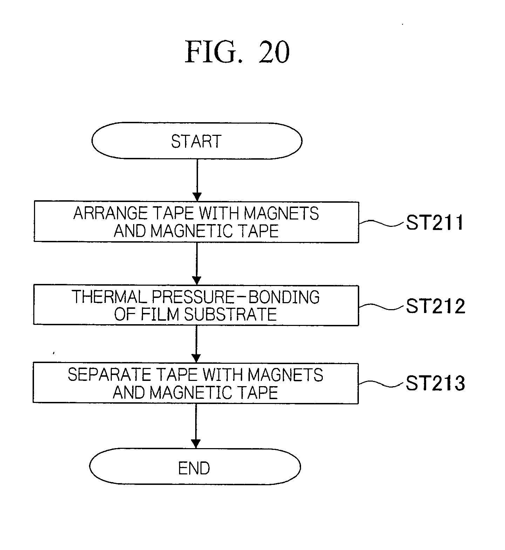

Here, the method of thermal pressure-bonding of IC chips 4 and the film substrate 3 by the thermal pressure-bonding portion 213 is explained in detail using Fig. 20.

First, the tape with magnets 225 and magnetic tape 226 are positioned on the upper and lower faces of the film substrate 3 on which IC chips 4 are mounted. Pressure is applied to the IC chips 4 and film substrate 3 by the magnetic attractive force of the tape with magnets 225 and magnetic tape 226 (step ST211).

While heating the film substrate 3 conveyed to the thermal pressure-bonding main unit 221 by means of high-temperature compressed air sprayed from the spray hole 221a, pressure is applied by means of the magnetic attractive force of the tape with magnets 225 and magnetic tape 226 (step ST212). Because a DC current is flowing through the conducting bars 224, a Lorentz force arises due to the magnetic tape 225 and DC current, and the film substrate 2, while being enclosed between the tape with magnets 225 and magnetic tape 226, is conveyed along the conveyor path of the thermal pressure-bonding portion main unit 221. Due to the high-temperature compressed air sprayed from the spray hole 221 a, the film substrate 3, tape with magnets 225, and magnetic tape 226 are lifted from the surface of the thermal pressure-bonding portion main unit 221, so that conveyance by the Lorentz force is performed smoothly.

The tape with magnets 225 and magnetic tape 226 are each separated from the film substrate 3 which has been conveyed from the thermal pressure-bonding portion main unit 221 (step ST213). By this means, the film substrate 3 and IC chips 4 are thermal pressure-bonded.

By means of an IC chip package production apparatus configured in this way, thermal pressure-bonding can be performed without temporarily stopping the film substrate 3, so that the efficiency of production of ID tags 2 is improved.

Moreover, a helical-shaped conveyor path is formed on the outer surface of the thermal pressure-bonding portion main unit 221, so that the dedicated space required for thermal pressure-bonding of IC chips 4 and the film substrate 3 can be reduced.

Moreover, by controlling the magnitude of the DC current flowing in the conducting bars 224, conveyance of the film substrate 3 can be performed with stability.

In the above embodiments, examples of application of this invention to an ID tag production apparatus were explained; but the invention can also be applied to apparatuses for production of cards on which ICs are mounted.

Further, in the above embodiments, antenna circuits has already been formed on the film substrate; but a device for fabrication of antenna circuits may be positioned before the adhesive printing device, so that film substrate on which antenna circuits are not formed is supplied.

Further, a construction may be adopted such that the cover film covers so as to enclose the antenna circuits and IC chips.

Further, the film substrate roller 221 may be freely rotatable.

Further, the thermal pressure-bonding portion main unit 221 may convey the film substrate by means of a motor, and a groove may be formed as the conveyor path.

This invention is not limited to the above embodiments, and various modifications can be made without deviating from the gist of the invention.

### INDUSTRIAL APPLICABILITY

By means of an IC chip package production apparatus of this invention, IC chips are mounted without temporarily stopping the film substrate, so that the efficiency of production of IC chip packages is improved. Further, there is no need to provide another mechanism to transfer IC chips between the IC chip supply portion and the roller, so that the construction of the IC chip mounting portion is simple, and device reliability is improved. Moreover, by means of an IC chip package production apparatus of this invention, at the time of thermal pressure-bonding, IC chips can be mounted and thermal pressure-bonding performed without temporarily stopping the film substrate, so that the efficiency of production of IC chip packages is improved, and the cost of IC chip packages is reduced. Moreover, the space required for thermal pressure-binding can be reduced.

## Claims

1. An apparatus for producing IC chip packages, comprising:
a conveyance portion, which conveys a film substrate; and,
an IC chip mounting portion, which mounts IC chips on said film substrate, and includes:
a roller, on the outer surface of which is formed with an IC chip holding portion, which mounts the IC chips on said film substrate by rotating and holding said IC chips;
an IC chip supply portion having a supply path which supplies a plurality of said IC chips successively; and
a chip feeder portion which feeds said IC chips from the supply end to said chip holding portion, with a supply end of said supply path faced to said chip holding portion.

2. The apparatus for producing IC chip packages according to claim 1, wherein said roller is arranged to be driven to approach toward and retreat from said supply end, and is provided with a driving mechanism to drive said roller to approach toward and retreat from said supply end.

3. The apparatus for producing IC chip packages according to claim 1 or claim 2, further comprising a chip holding portion which temporarily holds and stops said IC chips at the supply end of said supply path.

4. The apparatus for producing IC chip packages according to claim 3, wherein said chip holding portion comprises a suction-clamping mechanism to perform suction-clamping of said IC chips.

5. The apparatus for producing IC chip packages according to claim 1, wherein said IC chip holding portion comprises a plurality of compartments provided within the roller, and suction-clamping holes opening from the compartments onto the outer surface, said IC chips being held or released by controlling the air pressure within the compartments.

6. The apparatus for producing IC chip packages according to claim 5, wherein said compartments change between a negative-pressure state and a positive-pressure state in response to rotation of said roller.

7. The apparatus for producing IC chip packages according to claim 5 or claim 6, wherein said compartments comprise gaps within said roller and air path switching valves.

8. The apparatus for producing IC chip packages according to claim 7, wherein said air path switching valves are provided with a negative-pressure pipe and a positive-pressure pipe.

9. An apparatus for producing IC chip packages, comprising:
a conveyance portion, which conveys a film substrate;
an IC chip mounting portion, which mounts IC chips on said film substrate; and
a thermal pressure-bonding portion, which performs thermal pressure-bonding of said IC chips and said film substrate, and includes:
a pressure-application portion which applies pressure to said film substrate with IC chips mounted on said conveyor path without stopping the motion on the conveyor path which conveys said film substrate with IC chips mounted; and
a heat-application portion which applies heat to said film substrate with IC chips mounted on said conveyor path without stopping the motion.

10. The apparatus for producing IC chip packages according to claim 9, wherein said conveyor path is provided in a helical shape on the outer surface of said thermal pressure-bonding portion.

11. The apparatus for producing IC chip packages according to claim 9 or claim 10, wherein said pressure-application portion comprises a pair of pressure-application tapes having a relative attractive force and positioned at the upper and lower faces of said film substrate with IC chips mounted, said film substrate with IC chips mounted being pressure-bonded by enclosing said film substrate with IC chips mounted by said pair of pressure-application tapes.

12. The apparatus for producing IC chip packages according to claim 11, wherein said pair of pressure-application tapes applies pressure to said film substrate with IC chips mounted by means of a magnetic attractive force.

13. The apparatus for producing IC chip packages according to claim 11, further comprising an electrically conducting portion which conducts a DC current in a direction intersecting said conveyor path, wherein said film substrate with IC chips mounted is conveyed along said conveyor path by conducting said DC current in said electrically conducting portion to generate a Lorentz force with a tape with magnets,.

14. The apparatus for producing IC chip packages according to claim 11, wherein discharge holes which discharge high-pressure air are formed in said conveyor path, said film substrate with IC chips mounted and said pair of pressure-application tapes being conveyed while being lifted by said high-pressure air.

15. The apparatus for producing IC chip packages according to claim 14, wherein said heat-application portion discharges high-temperature high-pressure air from said discharge holes to heat said film substrate with IC chips mounted.
